Europäisches Patentamt

European Patent Office

Office européen des brevets

(19)

(11) **EP 0 887 966 A1**

(12) **EUROPEAN PATENT APPLICATION**

(43) Date of publication:
**30.12.1998 Bulletin 1998/53**

(51) Int. Cl.$^6$: **H04L 1/00**, H03M 13/00

(21) Application number: **98304995.8**

(22) Date of filing: **25.06.1998**

| | |
|---|---|
| (84) Designated Contracting States:<br>**AT BE CH CY DE DK ES FI FR GB GR IE IT LI LU MC NL PT SE**<br>Designated Extension States:<br>**AL LT LV MK RO SI**<br><br>(30) Priority: **25.06.1997 KR 9727070**<br><br>(71) Applicant:<br>**Samsung Electronics Co., Ltd.**<br>**Suwon-city, Kyungki-do (KR)** | (72) Inventor: **Kim, Min-Goo**<br>**Suwon-shi, Kyonggi-do (KR)**<br><br>(74) Representative:<br>**Lunt, Mark George Francis et al**<br>**Dibb Lupton Alsop**<br>**Fountain Precinct**<br>**Balm Green**<br>**Sheffield S1 1RZ (GB)** |

(54) **Convolutional encoding method and system**

(57)    There is provided a systematic convolutional encoding method for a digital communication system having a non-systematic convolutional encoder. In the method, first to n-th block code words are obtained by multiplying first to n convolutional code generating polynomials by an information polynomial upon input of an information word, one of the first to n-th block code words is converted to a systematic code word, and a new information word corresponding to the systematic code word is obtained. Then, a convolutional code is generated by encoding the new information code in the non-systematic convolutional encoder.

FIG. 4

EP 0 887 966 A1

## Description

The present invention relates to a convolutional encoding method and system for a digital communication system, and in particular, to a systematic punctured convolutional encoding method and system.

Error correction is very significant for a digital MODEM (Modulator-DEMdulator) and many error correction techniques have been developed. A convolutional code is one the many types of error correction code widely used for a mobile radio communication system and has been adopted as a standard for an air interface in a CDMA (Code Division Multiple Access) digital cellular system, IS-95.

A code rate (R)-1/2 convolutional code is non-systematic, and a first code word $c_1(x)$ and a second code word $c_2(x)$ are generated from an input information word $i(x)$, respectively, by

$$c_1(x) = g_1(x)i(x) \tag{1}$$

$$c_2(x) = g_2(x)i(x) \tag{2}$$

where the code words $c_1(x)$ and $c_2(x)$ are non-systematic, and the information word, which is not independent of the code words, can be obtained only by decoding.

A punctured convolutional code of a code rate larger than ½ can be obtained by periodically puncturing the code words $c_1(x)$ and $c_2(x)$ generated from equations (1) and (2), using a puncturing matrix A. The best form of the puncturing matrix A is well known within the field (see for example, G.Begin. D Haccoun, and C. Paquin, "Further results on high rate punctured convolutional codes for Viterbi and sequential decoding" IEEE Trans. Commun, vol. 38, pp1922-1928, 1990; J. Hagenauer, "Rate-compatible punctured convolutional codes (RCPC) and their applications" IEEE Trans. Commun., vol. 36, pp 389-400, Nov. 1990 and K.J. Hole, "New short constraint length rate (N-1)/N punctured convolutional codes for soft-decision Viterbi decoding", IEEE Trans. Inform. Theory, vol. IT-34 1079-1081, Sept. 1997. Since the puncturing matrix A is a non-systematic matrix, it follows that the code words generated by use of this matrix are non-systematic punctured convolutional codes.

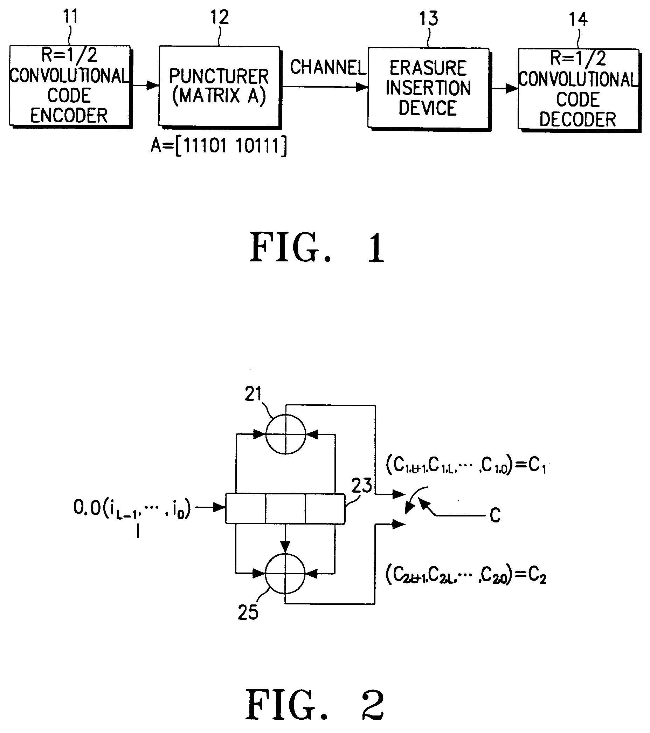

figure 1 is a block diagram of a conventional encoder and decoder of a rate-5/8 punctured convolutional code. Reference character A presents a puncturing matrix [11101 10111].

Conventional punctured convolutional codes are not available for a system requiring a systematic data because they are all generated from non-systematic puncturing matrices. With data and flames in systematic forms, much of processing delay can be varied, for example reduced, in a transmission system having an error corrector and detector which uses CRC (Cyclic Redundancy Check) for error detection. For example, to obtain a transmitted information word from a code word prior to decoding in the case of a current non-systematic convolutional code, a divider is required to divide the received code word by the code word generating polynomial g(x). Such a divider comprises a linear feedback shift registers (LFSRs) capable of storing as many data units as the order of the error correction code generating polynomial for the CRC. In addition, detection of the information word from the received code word involves as many processing delays and operations as there are bits constituting a code word. Hence, processing delay increases with code word size, that is, frame size. Frames sizes are large in, for example, a high multispeed hard disk driver or a high speed data transmission system such as ISDN (Integrated Services Digital Network). Due to a high transmission rate, even over a very short period of time, a single flame comprises many bits or symbols, which implies that a large amount of time is required to obtain a code word when encoding or an information word when decoding. The large amount of time adds to processing delay-related difficulties because it takes a long time to implement decoding using a Viterbi decoder. It will be appreciated that such decoding delays are not negligible in such systems.

An object of the present invention is to provide a systematic punctured convolutional encoding method and system in which a non-systematic code word is converted to a systematic code word.

Accordingly, a first aspect of the present invention provides a rate-1/2 convolutional encoding method for a digital communication system, comprising the steps of: obtaining first and second block code words by multiplying an input information word by first and second convolutional code generating polynomials, respectively; and generating a convolutional code word by interleaving the first and second code words with an interleaving depth ($\lambda$) of n.

Preferably, there is provided a method wherein the input information word exists in a systematic form in the second block code word $C_2(x)$ expressed as

$$C_2(x) = r_2(x) + x^m I(x)$$
$$= I_n(x)g_2(x)$$
$$= C_s(x)$$

where I(x) is the input word, $r_2(x)$ is a remainder after dividing $x^m I(x)$ by $g_2(x)$, m is the number of shifters, $I_n(x)$ is a information word polynomial, $g_2(x)$ is a code word generating polynomial for the second block code word, and $C_s(x)$ is a systematic code word.

A second aspect of the present invention provides a rate-1/n convolutional encoding method for a digital communication system having a non-systematic convolutional encoder, comprising the steps of: (a) obtaining first to n-th block code words by multiplying first to n convolutional code generating polynomials by an information polynomial upon input of an information word; (b) converting one of the first to n-th block code words to a systematic code word and obtaining a new information word, $I_n(x)$, corresponding to the systematic code word; and (c)

generating a convolutional code by encoding the new information code in the non-systematic convolutional encoder.

Preferably, an embodiment provides a method wherein one of the first to n-th block code words is selected and converted to the systematic code word using equation (1), and the new information word corresponding to the systematic code word is obtained using equation (2), in the step (b):

$$C_s(x) = r_q(x) + x^m I(x) \qquad (1)$$

where $C_s(x)$ is a code word of an sth block (s is one of 1, ...., n), I(x) is an input information word, $r_q(x)$ is the remainder after dividing $x^m I(x)$ by $g_s(x)$ which is an sth code word generating polynomial, and m is the number of shifters:

$$I_n(x) = C_s(x)/g_s(x) \qquad (2)$$

where $I_n(x)$ is a new information word.

A third aspect of the present invention provides a rate-k/n convolutional encoding method for a digital communication system having a non-systematic convolutional encoder, comprising the steps of: obtaining first to n-th block code words by multiplying first to n convolutional code generating polynomials by an information polynomial upon input of an information word; converting one of the first to n-th block code words to a systematic code word and obtaining a new information word corresponding to the systematic code word; generating a convolutional code by encoding the new information code in the non-systematic convolutional encoder; and systematically puncturing the convolutional code using a predetermined puncturing matrix.

Preferably, an embodiment provides a method wherein the predetermined puncturing matrix satisfies the following conditions: (condition 1) all elements of one row vectors are 1s; (condition 2) a convolutional code generated is non-catastrophic; and (condition 3) the generated convolutional code has the largest value of minimum free distance (d-free) and a minimum information code error after decoding.

Still more preferably, an embodiment provides a method wherein the puncturing matrix is selected from given matrices according to a corresponding code rate, and the convolutional code is punctured according to a weight spectrum corresponding to the selected puncturing matrix.

Accordingly, a fourth aspect of the present invention provides a rate-1/2 convolutional encoding system for a digital communication system, comprising means for obtaining first and second block code words by multiplying an input information word by first and second convolutional code generating polynomials, respectively; and means for generating a convolutional code word by interleaving the first and second code words with an interleaving depth ($\lambda$) of n.

Preferably, there is provided a system wherein the input information word exists in a systematic form in the second block code word $C_2(x)$ expressed as

$$\begin{aligned} C_2(x) &= r_2(x) + x^m I(x) \\ &= I_n(x) g_2(x) \\ &= C_s(x) \end{aligned}$$

where I(x) is the input word, $r_2(x)$ is a remainder after dividing $x^m I(x)$ by $g_2(x)$, m is the number of shifters, $I_n(x)$ is an information word polynomial, $g_2(x)$ is a code word generating polynomial for the second block code word, and $C_s(x)$ is a systematic code word.

A fifth aspect of the present invention provides a rate-1/n convolutional encoding system for a digital communication system having a non-systematic convolutional encoder, comprising: (a) means for obtaining first to n-th block code words by multiplying first to n convolutional code generating polynomials by an information polynomial upon input of an information word; (b) means for converting one of the first to n-th block code words to a systematic code word and obtaining a new information word, $I_n(x)$, corresponding to the systematic code word; and (c) means for generating a convolutional code by encoding the new information code in the non-systematic convolutional encoder.

Preferably, an embodiment provides a system wherein one of the first to n-th block code words is selected and converted to the systematic code word using equation (1), and the new information word corresponding to the systematic code word is obtained using equation (2) in the means (b):

$$C_s(x) = r_q(x) + x^m I(x) \qquad (1)$$

where $C_s(x)$ is a code word of an sth block (s is one of 1, ...., n), $I(x)$ is an input information word, $r_q(x)$ is the remainder after dividing $x^m I(x)$ by $g_s(x)$ which is an sth code word generating polynomial, and m is the number of shifters:

$$I_n(x) = C_s(x)/g_s(x) \qquad (2)$$

where $I_n(x)$ is a new information word.

A sixth aspect of the present invention provides a rate-k/n convolutional encoding system for a digital communication system having a non-systematic convolutional encoder, comprising: means for obtaining first to n-th block code words by multiplying first to n convolutional code generating polynomials by an information polynomial upon input of a information word; means for converting one of the first to n-th block code words to a systematic code word and means for obtaining a new information word corresponding to the systematic code word; generating a convolutional code by encoding the new information code in the non-systematic convolutional encoder; and means for systematically puncturing the convolutional code using a predetermined puncturing matrix.

Preferably, an embodiment provides a system wherein the predetermined puncturing matrix satisfies the following conditions: (condition 1) all elements of one of the row vectors are 1s; (condition 2) a convolutional code generated is non-catastrophic; and (condition 3) the generated convolutional code has the largest value of minimum free distance (d-free) and a minimum information code error after decoding.

Still more preferably, an embodiment provides a system wherein the puncturing matrix is selected from given matrices according to a corresponding code rate, and the convolutional code is punctured according to a weight spectrum corresponding to the selected puncturing matrix.

Embodiments of the present invention will now be described, by way of example only, with reference to the accompanying drawings in which:

figure 1 is a block diagram of a conventional encoder and decoder of a rate-5/8 punctured convolutional code;

figure 2 is a schematic view of a encoder of a rate-1/2 non-systematic convolutional code;

figure 3 is a schematic view of a systematic convolutional encoder according to an embodiment of the present invention;

figure 4 is a block diagram of an encoder of a systematic punctured convolutional code according to an embodiment of the present invention;

figures 5A, 5B and 5C illustrate the bit structures of code words;

figure 6 is a block diagram of a decoder of a systematic punctured convolutional code according to the embodiment of the present invention;

figure 7 is a table showing weight spectra of rate-2/3 systematic punctured convolutional codes generated from a known code with a code rate of 1/2, $3 \leq K \leq 7$, P of 2; and

figure 8 is a table showing weight spectra of systematic punctured convolutional codes generated from a known code with a code rate of 1/2, K of 7, $G_1 = [1011011]$, and $G_2 = [1111001]$.

Relying on the fact that every linear code has different sets of code words and that each code word of one set of code words corresponding to a code in another set of code words with the same code weight spectrum, a systematic code word is matched on a one-to-one basis with a corresponding code word according to the present invention so that systematic code words having the same code weight spectra as those of non-systematic convolutional or punctured convolutional code words can be obtained. The present invention therefore converts an information word corresponding to a non-systematic convolutional code into an information word corresponding to a systematic convolutional code.

1. Rate-1/2 convolutional code

A rate-1/2 convolutional code can be interpreted as being equivalent to an interleaved linear block code.

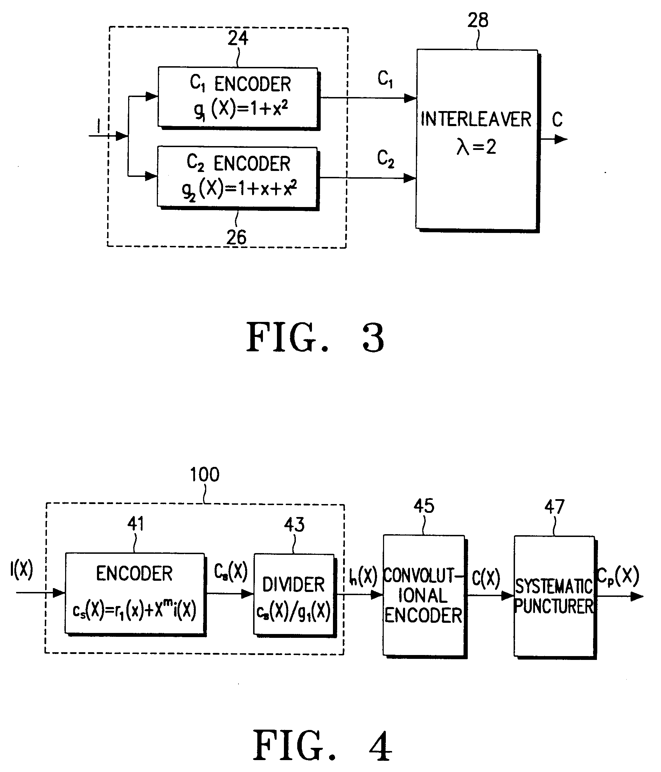

Figure 2 is a schematic view of a convolutional code encoder with a code rate of 1/2 and a constraint length (K) of 3. The convolutional encoder comprises two modulo-2 adders 21 and 25 and a shift register 23.

Figure 3 is a schematic view of a systematic convolutional encoder on the basis of the above interpretation. The encoder includes a $C_1$ encoder 24 and a $C_2$ encoder 26 for obtaining first and second block code words $C_1$ and $C_2$ by multiplying an input information word I by first and second convolutional code generating polynomials, respectively, and an interleaver 28 for generating a convolutional code word C by interleaving the first and second code words $C_1$ and $C_2$ with an interleaving depth ($\lambda$) of 2.

The above interpretation is valid for the reason described as follows. Assuming that a general convolutional code generating polynomial is $g_k(x)$ (k = 1, 2, ..., R) and an information word polynomial is I(x), a code word $C_k(x)$ (k = 1, 2, ..., R) can be expressed as

$$C_1(x) = g_1(x)I(x) \tag{3}$$

or more generally as

$$C_k(x) = g_k(x)I(x) \tag{4}$$

If each code word is considered to be a code word of a frame unit using zero-tail biting for block coding of a convolutional code, that is, a block code, there is produced a type of linear block code. Therefore, code words $C_k$ (k=1,2,...,R) are generated using the code generating polynomials $g_k(x)$ (k = 1,2, ..., R) and a code word C is obtained by interleaving these code words $C_k$ (k=1,2,...,R). All of the code words are non-systematic.

2. Rate-1/n systematic punctured convolutional code

Every linear block code has a set of systematic code words. Therefore, one code word is selected from R code words and converted to a systematic code word. Then, a new information word corresponding to this code word is input to a conventional non-systematic convolutional encoder. One of code words output from the encoder includes the first input information word. Thus, a systematic convolutional code can be generated.

3. Rate-k/n systematic punctured convolutional code

Puncturing is implemented to obtain a high-rate convolutional code using the systematic convolutional encoder realised above. Since it is important to retain a systematic code word, symbols of a code word selected as the systematic code word should be transmitted without puncturing. In addition, a puncturing matrix is used, which can make the punctured convolutional code non-catastrophic.

An encoder of a systematic punctured convolutional code will be described in detail with reference to figure 4. Referring to figure 4 there is shown a block diagram of the encoder of a systematic punctured convolutional encoder according to a embodiment of the present invention. Assuming that a convolutional code generating polynomial is the afore-described $g_k(x)$ (k = 1, 2,..., R) and an information word is $I_n(x)$, a code word $C_k(x)$ (k= 1,2,..., R) generated from the encoder of figure 4 can be expressed as

$$C_1(x) = g_1(x)I_n(x) \tag{5}$$

$$C_k(x) = g_k(x)I_n(x) \tag{6}$$

If the first input information word is I(x), the encoder 41 generates a systematic code word $C_s(x)$ from I(x). Although any of R generating polynomials can be used, the performance of the systematic convolutional code varies depending upon the selection of the generating polynomial. Thus, a generating polynomial allowing the best performance should be explored by simulation. As shown in the drawing, a divider 43 uses a generating polynomial $g_1(x)$.

The systematic code word $C_s(x)$ is converted to a new information word $I_n(x)$ by the divider 43. This new information word $I_n(x)$, resulting in non-systematic code words, is input to a conventional convolutional encoder 45. Thus, a convolutional code word generated from the new information word $I_k(x)$ is non-systematic. As is noted from a comparison between the code word C(x) and the first input information word I(x), a code word generated from the convolutional encoder 45 is always systematic if the generating polynomial $g_k(x)$ is used in the systematic code encoder 41. For example, by use if $g_2(x)$, the first input information word I(x) exists in $C_2(x)$ in a systematic form as shown in the following

equation:

$$C_2(x) = r_2(x) + x^m l(x)$$
$$= l_n(x)g_2(x)$$
$$= C_s(x) \quad (7)$$

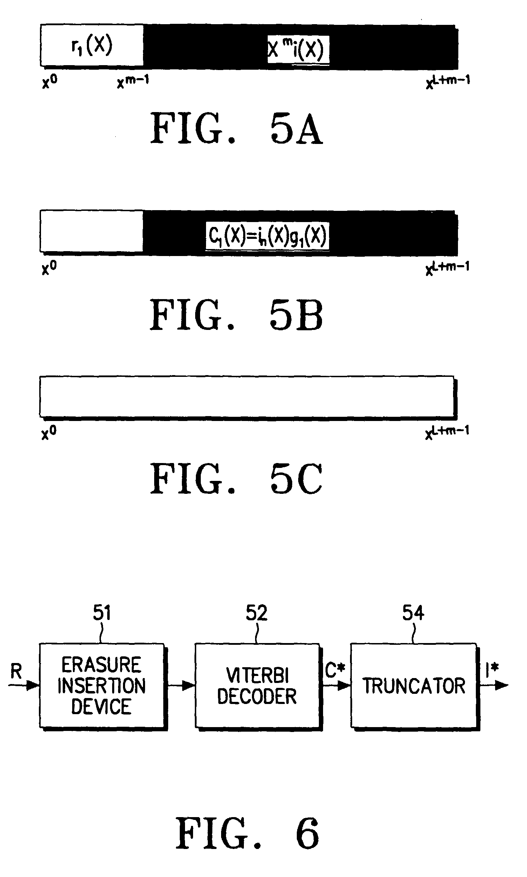

where $r_2(x)$ is a remainder produced from dividing $x^m l(x)$ by $g_2(x)$ and m is the number of shifters. Therefore, the code word $C(x)$ is a systematic convolutional code. Figures 5A, 5B and 5C illustrate the bit structures of code words, respectively for $C_1(x)$, $C_2(x)$ and $C_i(x)$. It will be appreciated from equations (7) that, for example, a code word $C_1(x)$ is a non-systematic code word with respect to $l_n(x)$ whilst simultaneously being a systematic code word with respect to $l(x)$. Therefore, the code word $C_1(x)$ can be considered to a systematic code word or a non-systematic code word according to the selection of the appropriate information word.

The selection of a puncturing matrix for operating a systematic puncturer 47 will now be described. The systematic puncturer 47 periodically punctures symbols of $C(x)$. Here, a puncturing matrix used is A given as [R x P]. When an element of this matrix is 0, a corresponding symbol is punctured and not transmitted. For generation of a systematic code word, the puncturing matrix should satisfy the following conditions:

(1) all elements in one of the row vectors of the puncturing matrix A are 1s

(2) a convolutional code word generated by use of the puncturing matrix A should be non-catastrophic; and

(3) the convolutional code generated by use of the puncturing matrix A should have the largest minimum free distance and a minimum information word error after decoding.

Referring to figure 6, the operation of a decoder of the systematic punctured convolutional code will be described.

Referring to figure 5, although $C(x)$ is a non-systematic code, one of R code words in the code is a systematic code word, that is $C_k(x)$ corresponding to $g_k(x)$ used for generating a systematic code in the encoder. To realise the decoder of a systematic punctured convolutional code, a erasure insertion device 51 inserts a erasure bit in the location of a code word punctured by the systematic puncturer 47 of figure 4. Then, a Viterbi decoder 52 decodes the erasure bit-inserted code word by a known method and selects $C_s$ from decoded code words. A truncator 54 separates symbols corresponding to the information word $l(x)$ from the symbols of the code word according to equation (7).

The systematic punctured convolutional code in the present invention exhibits an excellent performance at a high rate, as compared to that used in a Viterbi chip of Qualcomm. In other words, because the performance difference between a non-systematic convolutional code and a systematic convolutional code increases with a higher rate, the systematic convolutional code can be significantly used for high speed transmission, a high rate coding scheme, and CDMA PCS (Personal Communication System) or FPLMTS (Future Public Land Mobile Telecommunication System) for data transmission, that is, packet transmission.

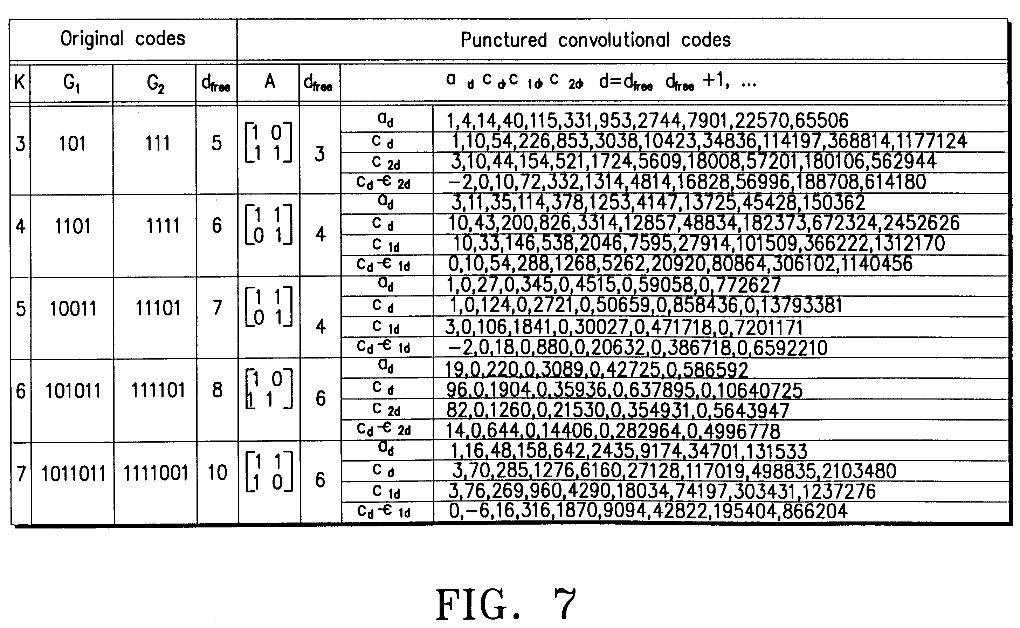

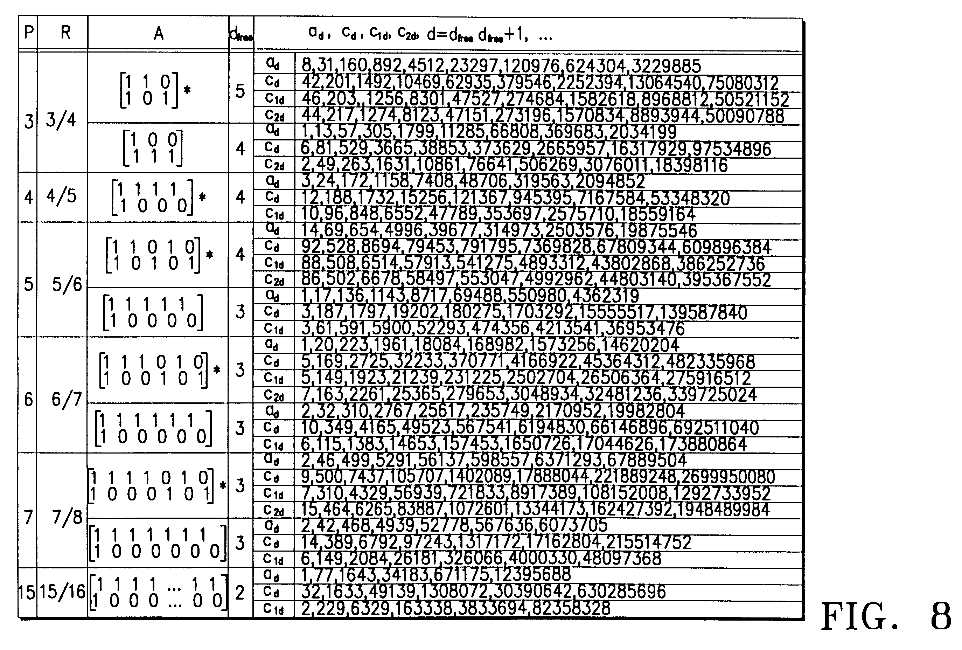

Figure 7 is a table showing the weight spectra of rate-2/3 systematic punctured convolutional codes generated using a known code with a code rate of 1/2, $3 \leq K \leq 7$, a puncturing period (P) of 2, and figure 8 is a table showing weight spectra of systematic punctured convolutional codes generated a known code with a code rate of 1/2, K of 7, $G_1$ = [1011011], and $G_2$ = [1111001].

As described above, the present invention advantageously allows an information word to be directly obtained from received code words without passing through a decoder and thus it can be determined in a short period of time whether the received code words should be decoded. Although the performances of known systematic convolutional and punctured convolutional codes are considered as inferior to those of known non-systematic convolutional and punctured convolutional codes, the systematic convolutional and punctured convolutional codes of the present invention have the same code weight spectra as those of non-systematic ones and exhibit performances equal to or better at high data rates than the non-systematic ones.

While the present embodiment has been described in detail with reference to the specific embodiment of the present invention, it is a mere exemplary application. Thus, it is to be clearly understood that may variations can be made by anyone skilled in the art within the scope and spirit of the present invention.

## Claims

1. A rate-1/2 convolutional encoding method for a digital communication system, comprising the steps of:

obtaining first and second block code words by multiplying an input information word by first and second convolutional code generating polynomials, respectively; and

generating a convolutional code word by interleaving the first and second code words with a interleaving depth ($\lambda$) of n.

2. The method of claim 1, wherein the input information word exists in a systematic form in the second block code word $C_2(x)$ expressed as

$$C_2(x) = r_2(x) + x^m l(x)$$
$$= l_n(x)g_2(x)$$
$$= C_s(x)$$

where $l(x)$ is the input word, $r_2(x)$ is a remainder after dividing $x^m l(x)$ by $g_2(x)$, m is the number of shifters, $l_n(x)$ is an information word polynomial, $g_2(x)$ is a code word generating polynomial for the second block code word, and $C_s(x)$ is a systematic code word.

3. A rate-1/n convolutional encoding method for a digital communication system having a non-systematic convolutional encoder, comprising the steps of:

(a) obtaining first to n-th block code words by multiplying first to n convolutional code generating polynomials by an information polynomial upon input of an information word;

(b) converting one of the first to n-th block code words to a systematic code word and obtaining a new information word, $l_n(x)$, corresponding to the systematic code word; and

(c) generating a convolutional code by encoding the new information code in the non-systematic convolutional encoder.

4. The method of claim 3, wherein one of the first to n-th block code words is selected and converted to the systematic code word using equation (1), and the new information word corresponding to the systematic code word is obtained using equation (2), in the step (b):

$$C_s(x) = r_q(x) + x^m l(x) \tag{1}$$

where $C_s(x)$ is a code word of a sth block (s is one of 1, ...., n), $l(x)$ is an input information word, $r_q(x)$ is the remainder after dividing $x^m l(x)$ by $g_s(x)$ which is an sth code word generating polynomial, and m is the number of shifters:

$$l_n(x) = C_s(x)/g_s(x) \tag{2}$$

where $l_n(x)$ is a new information word.

5. A rate-k/n convolutional encoding method for a digital communication system having a non-systematic convolutional encoder, comprising the steps of:

obtaining first to n-th block code words by multiplying first to n convolutional code generating polynomials by an information polynomial upon input of an information word;

converting one of the first to n-th block code words to a systematic code word and obtaining a new information word corresponding to the systematic code word;

generating a convolutional code by encoding the new information code in the non-systematic convolutional encoder; and

systematically puncturing the convolutional code using a predetermined puncturing matrix.

**6.** The method of claim 5, wherein the predetermined puncturing matrix satisfies the following conditions:

(condition 1) all elements of one row vectors are 1s;

(condition 2) a convolutional code generated is non-catastrophic; and

(condition 3) the generated convolutional code has the largest value of minimum free distance (d-free) and a minimum information code error after decoding.

**7.** The method of claim 6, wherein the puncturing matrix is selected from given matrices according to a corresponding code rate, and the convolutional code is punctured according to a weight spectrum corresponding to the selected puncturing matrix.

**8.** The method of claim 7, wherein the given puncturing matrices and corresponding weight spectra thereto are listed in the following table:

| input information | | | | puncturing matrix |
|---|---|---|---|---|
| constraint length (k) | first generating polynomial ($G_1$) | second generating polynomial ($G_2$) | d-free | |
| 3 | 101 | 111 | 5 | $\begin{bmatrix} 10 \\ 11 \end{bmatrix}$ |
| 4 | 1101 | 1111 | 6 | $\begin{bmatrix} 11 \\ 01 \end{bmatrix}$ |
| 5 | 10011 | 11101 | 7 | $\begin{bmatrix} 11 \\ 01 \end{bmatrix}$ |
| 6 | 101011 | 111101 | 8 | $\begin{bmatrix} 10 \\ 11 \end{bmatrix}$ |
| 7 | 1011011 | 1111001 | 10 | $\begin{bmatrix} 11 \\ 10 \end{bmatrix}$ |

**9.** A systematic punctured convolutional encoding method substantially as described herein with reference to and/or as illustrated in figures 3 to 8.

**10.** A rate-1/2 convolutional encoding system for a digital communication system, comprising:

means for obtaining first and second block code words by multiplying an input information word by first and second convolutional code generating polynomials, respectively; and
means for generating a convolutional code word by interleaving the first and second code words with an interleaving depth ($\lambda$) of n.

**11.** A system as claimed in claim 10, wherein the input information word exists in a systematic form in the second block code word $C_2(x)$ expressed as

$$C_2(x) = r_2(x) + x^m I(x)$$
$$= I_m(x) g_2(x)$$
$$= C_s(x)$$

where $I(x)$ is the input word, $r_2(x)$ is a remainder after dividing $x^m I(x)$ by $g_2(x)$, m is the number of shifters, $I_m(x)$ is an information word polynomial, $g_2(x)$ is a code word generating polynomial for the second block code word, and $C_s(x)$ is a systematic code word.

**12.** A rate-1/n convolutional encoding system for a digital communication system having a non-systematic convolutional encoder, comprising:

(a) means for obtaining first to n-th block code words by multiplying first to n convolutional code generating polynomials by an information polynomial upon input of an information word;

(b) means for converting one of the first to n-th block code words to a systematic code word and obtaining a new information word, $I_n(x)$, corresponding to the systematic code word; and

(c) means for generating a convolutional code by encoding the new information code in the non-systematic convolutional encoder.

**13.** A system as claimed in claim 12, wherein one of the first to n-th block code words is selected and converted to the systematic code word using equation (1), and the new information word corresponding to the systematic code word is obtained using equation (2), in the means (b):

$$C_s(x) = r_q(x) + x^m I(x) \tag{1}$$

where $C_s(x)$ is a code word of an sth block (s is one of 1, ...., n), $I(x)$ is an input information word, $r_q(x)$ is the remainder after dividing $x^m I(x)$ by $g_s(x)$ which is an sth code word generating polynomial, and m is the number of shifters:

$$I_n(x) = C_s(x)/g_s(x) \tag{2}$$

where $I_n(x)$ is a new information word.

**14.** A rate-k/n convolutional encoding system for a digital communication system having a non-systematic convolutional encoder, comprising:

means for obtaining first to n-th block code words by multiplying first to n convolutional code generating polynomials by an information polynomial upon input of an information word;

means for converting one of the first to n-th block code words to a systematic code word and obtaining a new information word corresponding to the systematic code word;

means for generating a convolutional code by encoding the new information code in the non-systematic convolutional encoder; and

means for systematically puncturing the convolutional code using a predetermined puncturing matrix.

**15.** A system as claimed in claim 14, wherein the predetermined puncturing matrix satisfies the following conditions:

(condition 1) all elements of one row vectors are 1s;

(condition 2) a convolutional code generated is non-catastrophic; and

(condition 3) the generated convolutional code has the largest value of minimum free distance (d-free) and a minimum information code error after decoding.

16. A system as claimed in claim 15, wherein the puncturing matrix is selected from given matrices according to a corresponding code rate, and the convolutional code is punctured according to a weight spectrum corresponding to the selected puncturing matrix.

17. A system as claimed in claim 16, wherein the given puncturing matrices and corresponding weight spectra thereto are listed in the following table:

| input information | | | | puncturing matrix |
|---|---|---|---|---|
| constraint length (k) | first generating polynomial (G$_1$) | second generating polynomial (G$_2$) | d-free | |
| 3 | 101 | 111 | 5 | $\begin{bmatrix} 10 \\ 11 \end{bmatrix}$ |
| 4 | 1101 | 1111 | 6 | $\begin{bmatrix} 11 \\ 01 \end{bmatrix}$ |
| 5 | 10011 | 11101 | 7 | $\begin{bmatrix} 11 \\ 01 \end{bmatrix}$ |
| 6 | 101011 | 111101 | 8 | $\begin{bmatrix} 10 \\ 11 \end{bmatrix}$ |
| 7 | 1011011 | 1111001 | 10 | $\begin{bmatrix} 11 \\ 10 \end{bmatrix}$ |

18. A systematic punctured convolutional encoding system substantially as described herein with reference to and/or as illustrated in figures 3 to 8.

FIG. 1

FIG. 2

FIG. 3

FIG. 4

$$r_1(X) \qquad X^m i(X)$$

$x^0 \qquad x^{m-1} \qquad\qquad\qquad\qquad x^{L+m-1}$

# FIG. 5A

$$C_1(X)=i_n(X)g_1(X)$$

$x^0 \qquad\qquad\qquad\qquad\qquad\qquad x^{L+m-1}$

# FIG. 5B

$x^0 \qquad\qquad\qquad\qquad\qquad\qquad x^{L+m-1}$

# FIG. 5C

| 51 | 52 | 54 |
|---|---|---|
| ERASURE INSERTION DEVICE | VITERBI DECODER | TRUNCATOR |

R → | ERASURE INSERTION DEVICE | → | VITERBI DECODER | C* → | TRUNCATOR | → I*

# FIG. 6

| Original codes | | | | Punctured convolutional codes | | |
|---|---|---|---|---|---|---|
| K | $G_1$ | $G_2$ | $d_{free}$ | A | $d_{free}$ | $a_d$ $c_d$ $c_{1d}$ $c_{2d}$ $d=d_{free}$ $d_{free}+1, \ldots$ |
| 3 | 101 | 111 | 5 | $\begin{bmatrix} 1 & 0 \\ 1 & 1 \end{bmatrix}$ | 3 | $a_d$: 1,4,14,40,115,331,953,2744,7901,22570,65506 |
| | | | | | | $c_d$: 1,10,54,226,853,3038,10423,34836,114197,368814,1177124 |
| | | | | | | $c_{2d}$: 3,10,44,154,521,1724,5609,18008,57201,180106,562944 |
| | | | | | | $c_d - c_{2d}$: −2,0,10,72,332,1314,4814,16828,56996,188708,614180 |
| 4 | 1101 | 1111 | 6 | $\begin{bmatrix} 1 & 1 \\ 0 & 1 \end{bmatrix}$ | 4 | $a_d$: 3,11,35,114,378,1253,4147,13725,45428,150362 |
| | | | | | | $c_d$: 10,43,200,826,3314,12857,48834,182373,672324,2452626 |
| | | | | | | $c_{1d}$: 10,33,146,538,2046,7595,27914,101509,366222,1312170 |
| | | | | | | $c_d - c_{1d}$: 0,10,54,288,1268,5262,20920,80864,306102,1140456 |
| 5 | 10011 | 11101 | 7 | $\begin{bmatrix} 1 & 1 \\ 0 & 1 \end{bmatrix}$ | 4 | $a_d$: 1,0,27,0,345,0,4515,0,59058,0,772627 |
| | | | | | | $c_d$: 1,0,124,0,2721,0,50659,0,858436,0,13793381 |
| | | | | | | $c_{1d}$: 3,0,106,1841,0,30027,0,471718,0,7201171 |
| | | | | | | $c_d - c_{1d}$: −2,0,18,0,880,0,20632,0,386718,0,6592210 |
| 6 | 101011 | 111101 | 8 | $\begin{bmatrix} 1 & 0 \\ 1 & 1 \end{bmatrix}$ | 6 | $a_d$: 19,0,220,0,3089,0,42725,0,586592 |
| | | | | | | $c_d$: 96,0,1904,0,35936,0,637895,0,10640725 |
| | | | | | | $c_{2d}$: 82,0,1260,0,21530,0,354931,0,5643947 |
| | | | | | | $c_d - c_{2d}$: 14,0,644,0,14406,0,282964,0,4996778 |
| 7 | 1011011 | 1111001 | 10 | $\begin{bmatrix} 1 & 1 \\ 1 & 0 \end{bmatrix}$ | 6 | $a_d$: 1,16,48,158,642,2435,9174,34701,131533 |
| | | | | | | $c_d$: 3,70,285,1276,6160,27128,117019,498835,2103480 |
| | | | | | | $c_{1d}$: 3,76,269,960,4290,18034,74197,303431,1237276 |
| | | | | | | $c_d - c_{1d}$: 0,−6,16,316,1870,9094,42822,195404,866204 |

# FIG. 7

EP 0 887 966 A1

EP 0 887 966 A1

| P | R | A | $d_{free}$ | | $a_d$, $c_d$, $c_{1d}$, $c_{2d}$, $d=d_{free}$ $d_{free}+1$, ... |
|---|---|---|---|---|---|
| 3 | 3/4 | $\begin{bmatrix} 1 & 1 & 0 \\ 1 & 0 & 1 \end{bmatrix}*$ | 5 | $a_d$ | 8,31,160,892,4512,23297,120976,624304,3229885 |
| | | | | $c_d$ | 42,201,1492,10469,62935,379546,2252394,13064540,75080312 |
| | | | | $c_{1d}$ | 46,203,1256,8301,47527,274684,1582618,8968812,50521152 |
| | | | | $c_{2d}$ | 44,217,1274,8123,47151,273196,1570834,8893944,50090788 |
| | | $\begin{bmatrix} 1 & 0 & 0 \\ 1 & 1 & 1 \end{bmatrix}$ | 4 | $a_d$ | 1,13,57,305,1799,11285,66808,369683,2034199 |
| | | | | $c_d$ | 6,81,529,3665,38853,373629,2665957,16317929,97534896 |
| | | | | $c_{2d}$ | 2,49,263,1631,10861,76641,506269,3076011,18398116 |
| 4 | 4/5 | $\begin{bmatrix} 1 & 1 & 1 & 1 \\ 1 & 0 & 0 & 0 \end{bmatrix}*$ | 4 | $a_d$ | 3,24,172,1158,7408,48706,319563,2094852 |
| | | | | $c_d$ | 12,188,1732,15256,121367,945395,7167584,53348320 |
| | | | | $c_{1d}$ | 10,96,848,6552,47789,353697,2575710,18559164 |
| 5 | 5/6 | $\begin{bmatrix} 1 & 1 & 0 & 1 & 0 \\ 1 & 0 & 1 & 0 & 1 \end{bmatrix}*$ | 4 | $a_d$ | 14,69,654,4996,39677,314973,2503576,19875546 |
| | | | | $c_d$ | 92,528,8694,79453,791795,7369828,67809344,609896384 |
| | | | | $c_{1d}$ | 88,508,6514,57913,541275,4893312,43802868,386252736 |
| | | | | $c_{2d}$ | 86,502,6678,58497,553047,4992962,44803140,395367552 |
| | | $\begin{bmatrix} 1 & 1 & 1 & 1 & 1 \\ 1 & 0 & 0 & 0 & 0 \end{bmatrix}$ | 3 | $a_d$ | 1,17,136,1143,8717,69488,550980,4362319 |
| | | | | $c_d$ | 3,187,1797,19202,180275,1703292,15555517,139587840 |
| | | | | $c_{1d}$ | 3,61,591,5900,52293,474356,4213541,36953476 |
| 6 | 6/7 | $\begin{bmatrix} 1 & 1 & 1 & 0 & 1 & 0 \\ 1 & 0 & 0 & 1 & 0 & 1 \end{bmatrix}*$ | 3 | $a_d$ | 1,20,223,1961,18084,168982,1573256,14620204 |
| | | | | $c_d$ | 5,169,2725,32233,370771,4166922,45364312,482335968 |
| | | | | $c_{1d}$ | 5,149,1923,21239,231225,2502704,26506364,275916512 |
| | | | | $c_{2d}$ | 7,163,2261,25365,279653,3048934,32481236,339725024 |
| | | $\begin{bmatrix} 1 & 1 & 1 & 1 & 1 & 1 \\ 1 & 0 & 0 & 0 & 0 & 0 \end{bmatrix}$ | 3 | $a_d$ | 2,32,310,2767,25617,235749,2170952,19982804 |
| | | | | $c_d$ | 10,349,4165,49523,567541,6194830,66146896,692511040 |
| | | | | $c_{1d}$ | 6,115,1383,14653,157453,1650726,17044626,173880864 |
| 7 | 7/8 | $\begin{bmatrix} 1 & 1 & 1 & 1 & 0 & 1 & 0 \\ 1 & 0 & 0 & 0 & 1 & 0 & 1 \end{bmatrix}*$ | 3 | $a_d$ | 2,46,499,5291,56137,598557,6371293,67889504 |
| | | | | $c_d$ | 9,500,7437,105707,1402089,17888044,221889248,2699950080 |
| | | | | $c_{1d}$ | 7,310,4329,56939,721833,8917389,108152008,1292733952 |
| | | | | $c_{2d}$ | 15,464,6265,83887,1072601,13344173,162427392,1948489984 |
| | | $\begin{bmatrix} 1 & 1 & 1 & 1 & 1 & 1 & 1 \\ 1 & 0 & 0 & 0 & 0 & 0 & 0 \end{bmatrix}$ | 3 | $a_d$ | 2,42,468,4939,52778,567636,6073705 |
| | | | | $c_d$ | 14,389,6792,97243,1317172,17162804,215514752 |
| | | | | $c_{1d}$ | 6,149,2084,26181,326066,4000330,48097368 |
| 15 | 15/16 | $\begin{bmatrix} 1 & 1 & 1 & 1 & \cdots & 1 & 1 \\ 1 & 0 & 0 & 0 & \cdots & 0 & 0 \end{bmatrix}$ | 2 | $a_d$ | 1,77,1643,34183,671175,12395688 |
| | | | | $c_d$ | 32,1633,49139,1308072,30390642,630285696 |
| | | | | $c_{1d}$ | 2,229,6329,163338,3833694,82358328 |

FIG. 8

**European Patent Office**

**EUROPEAN SEARCH REPORT**

Application Number

EP 98 30 4995

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | MIN-GOO KIM: "On Systematic Punctured Convolutional Codes" IEEE TRANSACTIONS ON COMMUNICATIONS, vol. 45, no. 2, February 1997, pages 133-139, XP002082006 * page 133, column 1, line 1 - page 139, column 2, last line; figures 1-6; tables I,II * | 1-16 | H04L1/00 H03M13/00 |

|  |  |  | TECHNICAL FIELDS SEARCHED (Int.Cl.6) |
|---|---|---|---|
|  |  |  | H03M |

The present search report has been drawn up for all claims

| Place of search | Date of completion of the search | Examiner |
|---|---|---|
| THE HAGUE | 26 October 1998 | Van Staveren, M |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

& : member of the same patent family, corresponding
  document

EPO FORM 1503 03.82 (P04C01)